Europäisches Patentamt

European Patent Office

Office européen des brevets

(11) Veröffentlichungsnummer: **0 389 680**
**A1**

## (12) EUROPÄISCHE PATENTANMELDUNG

(21) Anmeldenummer: **89121744.0**

(51) Int. Cl.⁵: **G01R 21/127**

(22) Anmeldetag: **24.11.89**

(30) Priorität: **31.03.89 CH 1186/89**

(43) Veröffentlichungstag der Anmeldung:
**03.10.90 Patentblatt 90/40**

(84) Benannte Vertragsstaaten:
**AT BE CH DE ES FR GB IT LI NL SE**

(71) Anmelder: **Landis & Gyr Betriebs AG**

**CH-6301 Zug(CH)**

(72) Erfinder: **Halder, Mathis**
**Burgmatt 28b**
**CH-6340 Baar(CH)**
Erfinder: **Frutiger, Theo**
**Kirchmattstrasse 28**
**CH-6312 Steinhausen(CH)**

(54) **Phasendetektor für impulsbreiten-impulslücken-modulierte Signale.**

(57) Der Phasendetektor (10) enthält einen Pulsamplitudenmodulator (11) und einen Integrator (12). Der Pulsamplitudenmodulator (11) weist einen Schalter (15) auf, der ein Umschalter ist und dessen Steuereingang von Impulsen gespeist ist, die mittels eines phasenverschobenen Signals impulsbreiten-impulslücken-moduliert sind, während der Amplitudeneingang (13) des Pulsamplitudenmodulators (11) von einem nichtphasenverschobenen Signal (u) gespeist ist. Der Integrator (12) enthält einen Integrationsverstärker (16), dessen Ausgang mittels eines Kondensators (C1) mit einem invertierenden Eingang des Integrationsverstärkers (16) verbunden ist und dessen nichtinvertierender Eingang über einen weiteren Kondensator (C2) an Masse liegt. Der invertierende und der nichtinvertierende Eingang des Integrationsverstärkers (16) sind über je einen Widerstand (R1 bzw. R2) mit zwei Eingängen des Integrators (12) verbunden, die ihrerseits einerseits über je einen Widerstand (R3 bzw. R4) an Masse liegen und anderseits über je einen Schalterkontakt des Umschalters mit dem Amplitudeneingang (13) des Pulsamplitudenmodulators (11) verbunden sind. Der Phasendetektor (10) benötigt nur einen einzigen Verstärker und wird in Phasenregelkreisen von statischen Elektrizitätszählern verwendet, die nach dem Impulsbreiten-Impulslücken-Impulsamplituden-Modulationsverfahren arbeiten sowie der Messung von Blindenergie dienen und daher einen 90°-Phasenschieber benötigen, der durch den Phasenregelkreis verwirklicht wird.

**Fig. 3**

Die Erfindung bezieht sich auf einen Phasendetektor für impulsbreiten-impulslücken-modulierte Signale gemäss dem Oberbegriff des Anspruchs 1.

Solche Phasendetektoren werden vorteilhaft in Phasenregelkreisen von statischen einphasigen oder mehrphasigen Elektrizitätszählern verwendet, die nach dem Impulsbreiten-Impulslücken-Impulsamplituden-Modulationsverfahren ("mark space amplitude modulation method") arbeiten sowie der Messung von Blindenergie dienen und daher bekanntlich einen 90°-Phasenschieber enthalten. Der Phasenregelkreis regelt die Phase seines Ausgangssignals $u_\phi$ derart, dass der Unterschied $\phi$ zwischen dieser Phase und der Phase seines Eingangssignals $u_O$ gleich 90° ist, so dass der Phasenregelkreis einen aktiven 90°-Phasenschieber darstellt.

Der Aufbau und die Arbeitsweise eines nach dem Impulsbreiten-Impulslücken-Impulsamplituden-Modulationsverfahren arbeitenden Elektrizitätszählers ist z. B. aus der US-PS 3 602 843 bekannt.

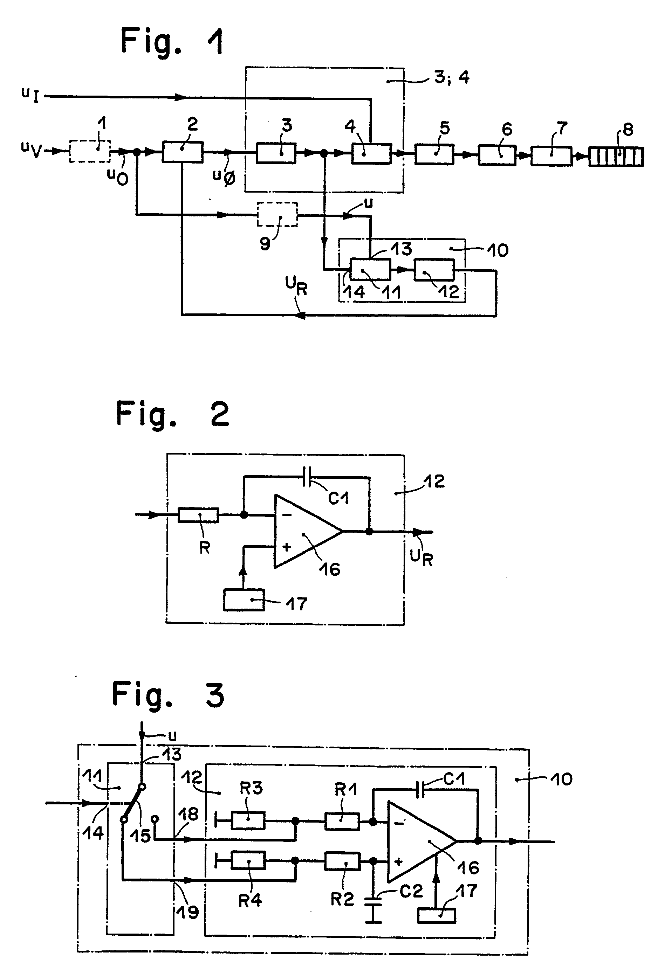

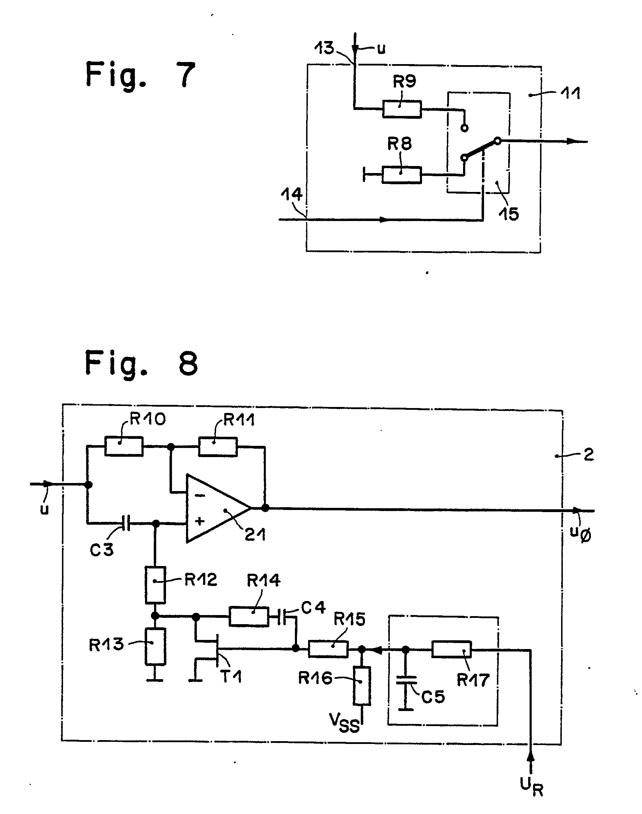

Ein mittels digitaler Bausteine aufgebauter und in einem Elektrizitätszähler für Blindenergie eingesetzter 90°-Phasenregelkreis und seine Arbeitsweise ist aus der US-PS 4 594 547 bekannt. Die dort erwähnten digitalen Bausteine können mindestens teilweise durch analoge Bausteine ersetzt werden, so insbesondere ein als Phasenschieber arbeitendes Verzögerungsglied durch einen analog arbeitenden in der Fig. 8 dargestellten Phasenschieber und ein als Integrator arbeitender Akkumulator durch einen analogen Integrator. Der Elektrizitätszähler für Blindenergie besitzt dann den in der Fig. 1 dargestellten Aufbau.

Der Erfindung liegt die Aufgabe zugrunde, sehr einfache Phasendetektor-Schaltungen für impulsbreiten-impulslücken-modulierte Signale zu realisieren, die einen geringen Aufwand an aktiven Bauelementen und nach Möglichkeit nur einen einzigen Verstärker benötigen.

Die genannte Aufgabe wird erfindungsgemäss durch die im Kennzeichen des Anspruchs 1. angegebenen Merkmale gelöst.

Vorteilhafte Ausstaltungen der Erfindung ergeben sich aus den Unteransprüchen.

Ausführungsbeispiele der Erfindung sind in der Zeichnung dargestellt und werden im folgenden näher beschrieben.

Es zeigen:

Fig. 1 ein Blockschaltbild eines Elektrizitätszählers für Blindenergie,

Fig. 2 ein Schaltbild eines Miller-Integrators,

Fig. 3 ein Schaltbild einer ersten Variante eines erfindungsgemässen Phasendetektors,

Fig. 4 ein Schaltbild einer zweiten Variante des erfindungsgemässen Phasendetektors,

Fig. 5 ein Schaltbild einer ersten Variante eines Pulsamplitudenmodulators,

Fig. 6 ein Schaltbild einer zweiten Variante des Pulsamplitudenmodulators,

Fig. 7 ein Schaltbild einer dritten Variante des Pulsamplitudenmodulators und

Fig. 8 ein Schaltbild eines Phasenschiebers.

Gleiche Bezugszahlen bezeichnen in allen Figuren der Zeichnung gleiche Teile.

Der in der Fig. 1 dargestellte Elektrizitätszähler für Blindenergie besteht aus einem fakultativ vorhandenen Anpassungsglied 1, einem Phasenschieber 2, einem Impulsbreiten-Impulslücken-Modulator ("mark space modulator") 3, einem Pulsamplitudenmodulator 4, einem Spannungs-Frequenz-Wandler 5, einem Frequenzteiler 6, einem Schrittmotor 7 mit Interfaceschaltung und einem Impulszählwerk 8, die alle in der angegebenen Reihenfolge in Kaskade geschaltet sind. Weiterhin sind vorhanden ein fakultativ vorhandenes Filter 9 und ein erfindungsgemässer Phasendetektor 10, der seinerseits aus einem weiteren Pulsamplitudenmodulator 11 und einem diesen in Kaskade nachgeschalteten Integrator 12 besteht. Eine Spannung $u_I$, die proportional einem Strom ist, speist einen Amplitudeneingang des Pulsamplitudenmodulators 4, während eine Spannung $u_V$, die proportional einer zum Strom gehörenden Spannung ist, entweder unmittelbar oder über das fakultativ vorhandene Anpassungsglied 1 den Eingang des Phasenschiebers 2 speist. Ein dadurch als Eingangssignal am Eingang des Phasenschiebers 2 anstehendes nichtphasenverschobenes Signal $u_O$ speist seinerseits ausserdem noch entweder unmittelbar oder über das fakultativ vorhandene Filter 9 einen Amplitudeneingang 13 des weiteren Pulsamplitudenmodulators 11. Der Ausgang des Impulsbreiten-Impulslücken-Modulators 3 ist ausserdem noch mit einem Impulseingang 14 des weiteren Pulsamplitudenmodulators 11 verbunden, während der Ausgang des Integrators 12 auf einen Steuereingang des Phasenschiebers 2 geführt ist.

Das Anpassungsglied 1, falls vorhanden, ist z. B. ein bekannter nichtinvertierender Verstärker und passt die Spannung $u_V$ pegelund/oder impedanzmässig an den Eingängen der nachfolgenden Schaltungen 2 und 9 bzw. 2 und 11 an. Der Phasenschieber 2, der Impulsbreiten-Impulslücken-Modulator 3 und der Phasendetektor 10 bilden den bereits erwähnten 90°-Phasenregelkreis, wobei das an seinem Eingang und damit am Eingang des Phasenschiebers 2 anstehende nichtphasenverschobene Signal $u_O$ im Phasenschieber 2 um einen Phasenwert $\phi$ phasenverschoben wird und das so erzeugte phasenverschobene Signal $u_\phi$ anschliessend die im Impulsbreiten- Impulslücken-Modulator 3 erzeugten Impulse impulsbreiten-impulslückenmoduliert. Diese impulsbreiten-impulslücken-modulierten Impulse speisen anschliessend je einen Impulseingang der beiden Pulsamplitudenmodulatoren 4 und 11 und werden einerseits in der Baugruppe 4;5;6;7;8 zur Erzeugung und Anzeige eines durch den Elektrizitätszähler gemessenen Blindenergiewertes und andererseits im Phasendetektor 10 zur Erzeugung einer Regelspannung $U_R$ ausgewertet, welche letztere ihrerseits als zur Sollwert-Istwert-Differenz proportionale Spannung auf den Steuereingang des Phasenschiebers 2 rückgekoppelt ist, wo sie den Phasenwert $\phi$ der zwischen den beiden Signalen $u_O$ und $u_\phi$ existierenden Phasenverschiebung solange regelt, bis im eingeschwungenen Zustand die Sollwert-Istwert-Differenz annähernd gleich Null ist. Dies ist der Fall, da der Sollwert gleich Null gewählt ist, wenn $\cos\phi = 0$ und damit $\phi = 90°$. Das nichtphasenverschobene Signal $u_O$ speist dabei seinerseits, nachdem es ggf. mittels des Filters 9, welches möglicherweise vorhandene Störsignale eliminiert, gefiltert wurde, den Amplitudeneingang 13 des Pulsamplitudenmodulators 11. Der Impulsbreiten-Impulslücken-Modulator 3 und je einer der beiden Pulsamplitudenmodulatoren 4 und 11 bilden zusammen je einen Impulsbreiten-Impulslücken-Impulsamplituden-Modulator 3;4 bzw. 3;11, die je als Multiplizierer in dem Sinne arbeiten, dass die Flächen ihrer Ausgangsimpulse proportional dem Produkt $u_\phi.u_I$ bzw. $u_\phi.u_O$ ihrer Eingangssignale $u_\phi$ und $u_I$ bzw. $u_\phi$ und $u_O$ sind.

Dies bedeutet, unter der Annahme
- dass die Signale $u_V$ und $u_I$ cosinusförmig sind, je eine Amplitude $U_V$ bzw. $U_I$ besitzen sowie einen Phasenunterschied $\alpha$ aufweisen und
- dass das Anpassungsglied 1 und das Filter 9 entweder nicht vorhanden sind oder je einen Verstärkungsfaktor Eins und keine Phasenverschiebung aufweisen,
dass, mit $\phi = 90°$, die Flächen der Ausgangsimpulse des Pulsamplitudenmodulators 4 proportional $U_V.U_I[\cos(\alpha + 90°) + \cos(2\Omega t + \alpha + 90°)]$ und die der Ausgangsimpulse des Pulsamplitudenmodulators 11 proportional $U_V.U_V[\cos\phi + \cos(2\Omega t + \phi)]$ sind. Die zweiten Terme werden jeweils durch einen im Spannungs-Frequenz-Wandler 5 enthaltenen Integrator bzw. durch den Integrator 12 eliminiert, so dass die Ausgangsfrequenz des Spannungs-Frequenz-Wandlers 5 proportional der Blindleistung $U_V.U_I.\sin\alpha$ und die Regelspannung $U_R$ am Ausgang des Integrators 12 proportional $(U_V)^2.\cos\phi$ ist, wobei im eingeschwungenen Zustand des Phasenregelkreises 2;3;10 der Phasenwert $\phi$ gleich $90°$ ist.

Die der Blindleistung proportionale Ausgangsfrequenz des Spannungs-Frequenz-Wandlers 5 wird noch im Frequenzteiler 6 geteilt und die Ausgangsimpulse des letzteren werden anschliessend noch mit Hilfe des Schrittmotors 7 und des Impulszählwerkes 8 gezählt zwecks Ermittlung der gemessenen Blindenergie.

In einer ersten Variante besitzt der Phasendetektor 10 den in der Fig. 3 dargestellten und in einer zweiten Variante den in der Fig. 4 wiedergegebenen Aufbau. In einer dritten bis fünften Variante des erfindungsgemässen Phasendetektors 10 ist der Integrator 12 ein Miller-Integrator und weist dann vorzugsweise den in der Fig. 2 dargestellten Aufbau auf.

In allen Varianten besitzt der Pulsamplitudenmodulator 11 einen Schalter 15, dessen Steuereingang den Impulseingang 14 des Pulsamplitudenmodulators 11 bildet und von Impulsen gespeist ist, die mittels des phasenverschobenen Signals $u_\phi$ impulsbreiten-impulslücken-moduliert sind. Der Integrator 12 enthält in allen Varianten einen Integrationsverstärker 16, dessen Ausgang mittels eines Kondensators C1 mit einem invertierenden Eingang des Integrationsverstärkers 16 verbunden ist. Letzterer ist vorzugsweise ein Operationsverstärker.

Der in der Fig. 2 dargestellte Miller-Integrator enthält den Integrationsverstärker 16 mit dem Kondensator C1. Sein invertierender Eingang ist innerhalb des Integrators 12 noch über einen Eingangswiderstand R auf den Eingang des Integrators 12 geführt, während ein nichtinvertierender Eingang des Integrationsverstärkers 16 am Ausgang eines Abgleichgliedes 17 angeschlossen ist, welches z. B. ein einstellbarer Spannungsteiler ist, mit dem der Nullabgleich des Integrationsverstärkers 16 erfolgen kann. Die Arbeitsweise des Miller-Integrators ist bekannt und wird daher nicht näher beschrieben.

Der in der Fig. 3 u.a. dargestellte Integrator 12 enthält ebenfalls den Integrationsverstärker 16 mit dem Kondensator C1. Sein nichtinvertierender Eingang liegt diesmal über einen weiteren Kondensator C2 an Masse. Der Schalter 15 des in der Fig. 3 ebenfalls dargestellten Pulsamplitudenmodulators 11 ist ein einpoliger Umschalter. Der invertierende und der nichtinvertierende Eingang des Integrationsverstärkers 16 sind über je einen Widerstand R1 bzw. R2 mit zwei Eingängen des Integrators 12 verbunden, die ihrerseits einerseits über je einen Widerstand R3 bzw. R4 an Masse liegen und anderseits auf je einen Ausgangspol 18 bzw. 19 des Pulsamplitudenmodulators 11 geführt sind. Die Ausgangspole 18 und 19 sind innerhalb des Pulsamplitudenmodulators 11 über je einen Schalterkontakt des Umschalters mit dem Amplitudeneingang 13 des Pulsamplitudenmodulators 11 verbunden. Der Ausgang des Abgleichgliedes 17 ist diesmal an einem Abgleicheingang des Integrationsverstärkers 16 angeschlossen.

Der Schalter 15 wird im Rhythmus der impulsbreiten-impulslückenmodulierten Ausgangsimpulse des Impulsbreiten-Impulslücken-Modulators 3 umgeschaltet. Dadurch werden diese Impulse durch das am Amplitudeneingang 13 des Pulsamplitudenmodulators 11 anstehende nichtphasenverschobene Signal $u_0$ bzw. beim Vorhandensein des Filters 9 durch das gefilterte nichtphasenverschobene Signal u, wenn u das Ausgangssignal des Filters 9 bezeichnet, amplitudenmoduliert. Die impulsbreiten-impulslücken-impulsamplitudenmodulierten Ausgangsimpulse des Pulsamplitudenmodulators 11 erreichen über eine zweipolige Verbindung den Integrationsverstärker 16, der als "differential integrator" beschaltet ist und dessen Ausgangssignal somit proportional der Differenz von zwei Integrationssignalen ist, wovon eines das Integrationssignal der Impulse und das andere das Integrationssignal der Impulslücken ist. Diese Differenz der beiden Integrationssignale entspricht dann dem Mittelwert der algebraischen Summe der Flächen aller Impulse und Impulslücken und ist wie bereits erwähnt proportional dem Produkt $(u_V)$-$^2 \cdot \cos\phi$. Das RC-Glied R1;C1 integriert die Flächen der Impulse und das RC-Glied R2;C2 integriert die Flächen der Impulslücken, während der Integrationsverstärker 16 u.a. der Differenzbildung der beiden Integrationswerte dient. Der in der Fig. 3 dargestellte Phasendetektor 10 hat den Vorteil, dass er nur einen einzigen Verstärker, nämlich den Integrationsverstärker 16 benötigt und somit nur eine einzige "Offset"-Spannung wirksam ist.

Der in der Fig. 4 u.a. dargestellte Integrator 12 enthält wieder den Integrationsverstärker 16 mit dem Kondensator C1. Sein nichtinvertierender Eingang liegt ebenfalls wieder über den Kondensator C2 an Masse. Der Schalter 15 des in der Fig. 4 ebenfalls dargestellten Pulsamplitudenmodulators 11 ist wieder ein einpoliger Umschalter. Der invertierende und der nichtinvertierende Eingang des Integrationsverstärkers 16 sind über je einen Widerstand R1 bzw. R2 mit je einem von zwei Ausgangspolen 18 bzw. 19 des Pulsamplitudenmodulators 11 verbunden, die ihrerseits innerhalb des Pulsamplitudenmodulators 11 einerseits über je einen weiteren Widerstand R3 bzw. R4 mit dem Amplitudeneingang 13 des Pulsamplitudenmodulators 11 und anderseits über je einen Schalterkontakt des Umschalters mit Masse verbunden sind. Der Ausgang des Abgleichgliedes 17 ist wieder an einem Abgleicheingang des Integrationsverstärkers 16 angeschlossen.

Der in der Fig. 4 dargestellte Phasendetektor 10 arbeitet ähnlich wie der in Fig. 3 dargestellte Phasendetektor 10, mit dem Unterschied, dass die beiden Widerstände R3 und R4 nicht im Integrator 12, sondern im Pulsamplitudenmodulator 11 enthalten sind. Der Phasendetektor 10 braucht wieder nur einen einzigen Verstärker, nämlich den Integrationsverstärker 16, und somit ist nur wieder eine einzige "Offset"-Spannung wirksam.

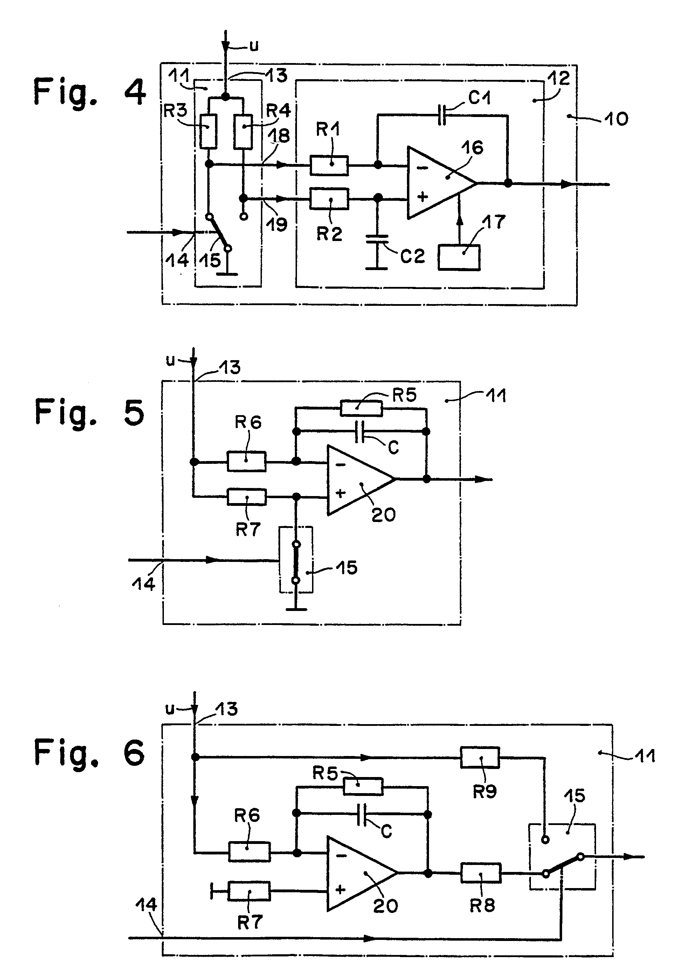

Der in der Fig. 5 dargestellte Pulsamplitudenmodulator 11 enthält einen Verstärker 20. Ein invertierender Eingang des Verstärkers 20 ist einerseits mindestens über einen Rück kopplungswiderstand R5 mit einem Ausgang des Verstärkers 20 und anderseits über einen ersten Eingangswiderstand R6 mit dem Amplitudeneingang 13 des Pulsamplitudenmodulators 11 verbunden. Ein nichtinvertierender Eingang des Verstärkers 20 ist dagegen einerseits über den Schalter 15 mit Masse und anderseits über einen zweiten Eingangswiderstand R7 mit dem Amplitudeneingang 13 des Pulsamplitudenmodulators 11 verbunden. Der Schalter 15 ist vorzugsweise ein Oeffnungskontakt und ein Kondensator C kann fakultativ parallel zum Widerstand R5 geschaltet werden.

Der in der Fig. 5 dargestellte beschaltete Verstärker 20 der dritten Variante des Phasendetektors 10 arbeitet als bekannter mittels eines Operationsverstärkers aufgebauter Verstärker, der in einer Stellug des Schalters 15 vorzugsweise einen Verstärkungsfaktor "1" und in der andern Stellung des Schalters 15 vorzugsweise einen Verstärkungsfaktor "-1" aufweist, so dass die Polarität seines Ausgangssignals im Rhythmus der impulsbreitenimpulslücken-modulierten Ausgangsimpulse des Impulsbreiten-Impulslücken-Modulators 3 invertiert wird. Abwechselnd erscheinen somit die amplitudenmodulierten Impulse invertiert und nichtinvertiert am Eingang des nachgeschalteten Miller-Integrators 12, der somit abwechselnd die Impulse und die Impulslücken integriert.

Der in der Fig. 6 dargestellte Pulsamplitudenmodulator 11 der vierten Variante des Phasendetektors 10 enthält ebenfalls den Verstärker 20. Ein invertierender Eingang des Verstärkers 20 ist einerseits mindestens über den Rückkopplungswiderstand R5 mit einem Ausgang des Verstärkers 20 und anderseits über den ersten Eingangswiderstand R6 mit dem Amplitudeneingang 13 des Pulsamplitudenmodulators 11 verbunden. Ein nichtinvertierender Eingang des Verstärkers 20 liegt über den zweiten Eingangswiderstand R7 an Masse. Der Schalter 15 ist ein einpoliger Umschalter. Der Ausgang des Pulsamplitudenmodulators 11 ist innerhalb desselben in der angegebenen Reihenfolge über je einen Kontakt des Umschalters und je einen weiteren Widerstand R8 bzw. R9 mit dem Ausgang des Verstärkers 20 bzw. mit dem Amplitudeneingang 13 des Pulsamplitudenmodulators 11 verbunden.

Im in der Fig. 6 dargestellten Pulsamplitudenmodulator 11 arbeitet der beschaltete Verstärker 20 als invertierender Verstärker mit vorzugsweise einem Verstärkungsfaktor "-1". Die am Amplitudeneingang 13 des Pulsamplitudenmodulators 11 anstehende Spannung $u_0$ bzw. u erreicht im Takt der impulsbreiten-impulslücken-modulierten Ausgangsimpulse des Impulsbreiten-Impulslücken-Mmodulators 3 einmal nichtinvertiert unmittelbar über den Widerstand R9 und einmal invertiert über den Verstärker 20 und den Widerstand R8 den Ausgang des Pulsamplitudenmodulators 11 und damit den Eingang des nachgeschalteten Integrators 12, der dann gleich arbeitet wie der Integrator 12 der dritten Variante.

Der in der Fig. 7 dargestellte Pulsamplitudenmodulator 11 enthält einen einpoligen Umschalter als Schalter 15. Der Ausgang des Pulsamplitudenmodulators 11 ist innerhalb desselben in der angegebenen Reihenfolge über je einen Kontakt des Umschalters und je einen weiteren Widerstand R8 bzw. R9 mit Masse bzw. mit dem Amplitudeneingang 13 des Pulsamplitudenmodulators 11 verbunden.

Im in der Fig. 7 dargestellten Pulsamplitudenmodulator 11 werden die amplitudenmodulierten impulsbreiten-impulslücken-modulierten Impulse über den Widerstand R9 dem Ausgang des Pulsamplitudenmodulators 11 und damit dem Eingang des nachgeschalteten Miller-Integrators 12 zugeführt, während die Impulslücken unterdrückt werden, indem die Masse über den Widerstand R8 auf den Ausgang des Pulsamplitudenmodulators 11 und damit auf den Eingang des Miller-Integrators 12 gegeben wird. Auch diese fünfte Variante des Phasendetektors 10 hat den Vorteil, dass nur ein Verstärker, nämlich der Integrationsverstärker 16 benötigt wird und somit nur eine einzige "Offset"-Spannung wirksam ist.

Der in der Fig. 8 dargestellte Phasenschieber 2 besteht aus einem Operationsverstärker 21, dessen invertierender Eingang einerseits über einen Widerstand R10 mit dem Eingang des Phasenschiebers 2 und anderseits über einen Widerstand R11 mit einem Ausgang des Operationsverstärkers 21 verbunden ist, der gleichzeitig der Ausgang des Phasenschiebers 2 ist. Der nichtinvertierende Eingang des Operationsverstärkers 21 ist einerseits über einen Kondensator C3 mit dem Eingang des Phasenschiebers 2 und anderseits über einen Widerstand R12 mit einem gemeinsamen Pol eines Widerstandes R13, eines Feldeffekttransistors T1 und einer Reihenschaltung R14;C4 eines Widerstandes R14 und eines Kondensators C4 verbunden. Das Gate des Feldeffekttransistors T1 ist mit einem zweiten Pol der Reihenschaltung R14;C4 und über einen Widerstand R15 mit einem gemeinsamen Pol eines Widerstandes R16, eines Kondensators C5 und eines Widerstandes R17 verbunden. Der zweite Pol des Widerstandes R17 bildet den Steuereingang des Phasenschiebers 2, an dem die vom Ausgang des Integrators 12 gelieferte Regelspannung $U_R$ ansteht, während der zweite Pol des Widerstandes R13 und des Kondensators C5 sowie der dritte Pol des Feldeffekttransistors T1 an Masse liegen. Der zweite Pol des Widerstandes R16 wird dagegen von einer Gleichspannung $V_{SS}$ gespeist, die z. B. -5 Volt beträgt und dazu dient, die Eingangsspannung des Feldeffekttransistors T1 auf eine Spannung zwischen 0 Volt und -5 Volt einzustellen.

Der in der Fig. 8 dargestellte Phasenschieber 2 enthält ein mittels des Operationsverstärkers 21 aufgebautes aktives Allpassfilter 21;R10;R11;C3;R12;R13;T1 erster Ordnung, dessen Phase mittels des als einstellbaren Widerstand arbeitenden Feldeffekttransistors T1 durch die Regelspannung $U_R$ auf $90^\circ$ eingeregelt wird. Die Regelspannung $U_R$ wird vorher noch durch das RC-Glied R17;C5 gefiltert und pegelmässig mittels der Spannung $V_{SS}$ und der Widerstände R15 und R16 an den Gateeingang des Feldeffekttransistors T1 angepasst.

## Ansprüche

1. Phasendetektor (10) für impulsbreiten-impulslücken-modulierte Signale, dadurch gekennzeichnet, dass ein Pulsamplitudenmodulator (11) und ein diesem nachgeschalteter Integrator (12) vorhanden sind, dass der Pulsamplitudenmodulator (11) einen Schalter (15) aufweist, dessen Steuereingang von Impulsen gespeist ist, die mittels eines phasenverschobenen Signals ($u_\phi$) impulsbreiten-impulslücken-moduliert sind, dass der Pulsamplitudenmodulator (11) einen Amplitudeneingang (13) besitzt, der von einem nichtphasenverschobenen Signal (u) gespeist ist, und dass der Integrator (12) einen Integrationsverstärker (16) enthält, dessen Ausgang mittels eines Kondensators (C1) mit einem invertierenden Eingang des Integrationsverstärkers (16) verbunden ist.

2. Phasendetektor (10) nach Anspruch 1, dadurch gekennzeichnet, dass der Integrator (12) ein Miller-Integrator ist, dass der Pulsamplitudenmodulator (11) einen Verstärker (20) enthält, dass ein invertierender Eingang dieses Verstärkers (20) einerseits mindestens über einen Rückkopplungswiderstand (R5) mit einem Ausgang des Verstärkers (20) des Pulsamplitudenmodulators (11) und anderseits über einen ersten Eingangswiderstand (R6) mit dem Amplitudeneingang (13) des Pulsamplitudenmodulators (11) verbunden ist und dass ein nichtinvertierender Eingang des Verstärkers (20) des Pulsamplitudenmodulators (11) einerseits über den Schalter (15) mit Masse und anderseits über einen zweiten Eingangswiderstand (R7) mit dem Amplitudeneingang (13) des Pulsamplitudenmodulators (11) verbunden ist.

3. Phasendetektor (10) nach Anspruch 1, dadurch gekennzeichnet, dass der Integrator (12) ein Miller-Integrator ist, dass der Pulsamplitudenmodulator (11) einen Verstärker (20) enthält, dass ein invertierender Eingang dieses Verstärkers (20) einerseits mindestens über einen Rückkopplungswiderstand (R5) mit einem Ausgang des Verstärkers (20) des Pulsamplitudenmodulators (11) und anderseits über einen ersten Eingangswiderstand (R6) mit dem Amplitudeneingang (13) des Pulsamplitudenmodulators (11) verbunden ist, dass ein nichtinvertierender Eingang des Verstärkers (20) des Pulsamplitudenmodulators (11) über einen zweiten Eingangswiderstand (R7) an Masse liegt, dass der Schalter (15) ein Umschalter ist und dass der Ausgang des Pulsamplitudenmodulators (11) in der angegebenen Reihenfolge über je einen Kontakt des Umschalters und je einen weiteren Widerstand (R8 bzw. R9) mit dem Ausgang des Verstärkers (20) des Pulsamplitudenmodulators (11) bzw. mit dem Amplitudeneingang (13) des Pulsamplitudenmodulators (11) verbunden ist.

4. Phasendetektor (10) nach Anspruch 1, dadurch gekennzeichnet, dass der Integrator (12) ein Miller-Integrator ist, dass der Schalter (15) ein Umschalter ist und dass der Ausgang des Pulsamplitudenmodulators (11) in der angegebenen Reihenfolge über je einen Kontakt des Umschalters und je einen weiteren Widerstand (R8 bzw. R9) mit Masse bzw. mit dem Amplitudeneingang (13) des Pulsamplitudenmodulators (11) verbunden ist.

5. Phasendetektor (10) nach Anspruch 1, dadurch gekennzeichnet, dass ein nichtinvertierender Eingang des Integrationsverstärkers (16) über einen weiteren Kondensator (C2) an Masse liegt, dass der Schalter (15) ein Umschalter ist, dass der invertierende und der nichtinvertierende Eingang des Integrationsverstärkers (16) über je einen Widerstand (R1 bzw. R2) mit zwei Eingängen des Integrators (12) verbunden sind, die ihrerseits einerseits über je einen Widerstand (R3 bzw. R4) an Masse liegen und anderseits über je einen Schalterkontakt des Umschalters mit dem Amplitudeneingang (13) des Pulsamplitudenmodulators (11) verbunden sind.

6. Phasendetektor (10) nach Anspruch 1, dadurch gekennzeichnet, dass ein nichtinvertierender Eingang des Integrationsverstärkers (16) über einen weiteren Kondensator (C2) an Masse liegt, dass der Schalter (15) ein Umschalter ist, dass der invertierende und der nichtinvertierende Eingang des Integrationsverstärkers (16) über je einen Widerstand (R1 bzw. R2) mit je einem von zwei Ausgangspolen (18, 19) des Pulsamplitudenmodulators (11) verbunden sind und dass die beiden Ausgangspole (18, 19) des Pulsamplitudenmodulators (11) einerseits über je einen weiteren Widerstand (R3 bzw. R4) mit dem Amplitudeneingang (13) des Pulsamplitudenmodulators (11) und anderseits über je einen Schalterkontakt des Umschalters mit Masse verbunden sind.

7. Verwendung eines Phasendetektors (10) nach einem der Ansprüche 1 bis 6 in einem Phasenregelkreis (2;3;10) eines Elektrizitätszählers für Blindenergie.

# Fig. 1

# Fig. 2

# Fig. 3

Fig. 4

Fig. 5

Fig. 6

Fig. 7

Fig. 8

Europäisches Patentamt

**EUROPÄISCHER RECHERCHENBERICHT**

Nummer der Anmeldung

EP 89 12 1744

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | CH-A- 472 677 (LANDIS & GYR) <br> * Spalte 3, Zeilen 8-45 * <br> --- | 1 | G 01 R 21/127 |
| A | EP-A-0 232 763 (SIEMENS) <br> --- | | |
| D,A | US-A-3 602 843 (LANDIS & GYR) <br> --- | | |
| D,A | DE-A-3 329 090 (LANDIS & GYR) <br> --- | | |
| A | DE-A-3 122 168 (TOKYO SHIBAURA) <br> ----- | | |
| | | | **RECHERCHIERTE SACHGEBIETE (Int. Cl.5)** |
| | | | G 01 R |

Der vorliegende Recherchenbericht wurde für alle Patentansprüche erstellt

| Recherchenort | Abschlußdatum der Recherche | Prüfer |
|---|---|---|
| DEN HAAG | 22-06-1990 | HOORNAERT W. |